Europäisches Patentamt

European Patent Office

Office européen des brevets

(11) Publication number: **0 673 111 A1**

# EUROPEAN PATENT APPLICATION

(21) Application number: **94200688.3**

(22) Date of filing: **17.03.94**

(51) Int. Cl.6: **H03F 3/343**, H03F 1/34, H03F 3/45

(43) Date of publication of application:
**20.09.95 Bulletin 95/38**

(84) Designated Contracting States:
**BE DE ES FR GB IT NL SE**

(71) Applicant: **BELL TELEPHONE MANUFACTURING COMPANY Naamloze Vennootschap**
**Francis Wellesplein 1**
**B-2018 Antwerp (BE)**

(84) **BE DE ES FR GB IT NL SE**

(72) Inventor: **Delbare, Wim Jozef Robert**
**Toleindestraat 204**
**B-9080 Beervelde (BE)**
Inventor: **Vandewege, Jan Alfons Oda Maria**
**Kalemeersstraat 5**
**B-9030 Mariakerke-Gent (BE)**
Inventor: **Verbeke, Jan Bert Maria**
**Herpinsakker 20**
**B-9800 Deinze (BE)**

(54) **Differential pair arrangement.**

(57) A differential pair arrangement is described consisting of the cascaded connection of a first and a second differential pair and an emitter follower. The second differential pair has local feedback resistances (R3, R3') providing an extra degree of freedom for designing the arrangement. The differential outputs are cross-coupled to the differential inputs via feedback resistances (Rf, Rf') so that negative feedback is obtained.

The present invention relates to a differential pair arrangement including between first and second poles of a DC supply source first and second differential pairs each including the series connection of two parallel individual first branches and a common second branch, each of said first branches including the series connection of a first impedance and a main path of a transistor, and said second branch including a common current source, with control electrodes of said transistors of said first differential pair constituting respective input terminals of said differential pair arrangement, with control electrodes of said transistors of said second differential pair being coupled to respective junction points of said first impedances and said transistors of said first differential pair, and with junction points of said first impedances and said transistors of said second differential pair being coupled to respective output terminals of said differential pair arrangement.

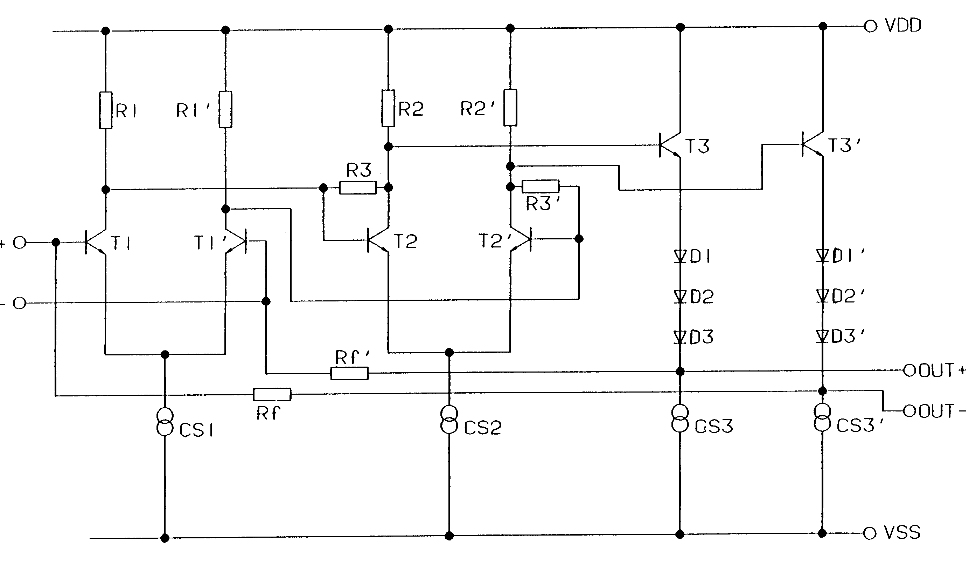

Such a differential pair arrangement is already known in the art, e.g. from the book 'Operational amplifiers, Design and Applications', by J.G. Graeme e.a., McGraw-Hill Book Company, 1971, pp. 119 - 130, more in particular from Fig 4.4 thereof. Therein, the common current source of the first differential pair includes the collector emitter path of a further transistor in series with a further resistance, the base electrode of the latter transistor being biased at a bias voltage provided by a resistive voltage divider. The common current source of the second differential pair is constituted by a second further resistance. The first branches include emitter degeneration resistances in series with the collector emitter paths of the transistors thereof. The second differential pair furthermore drives a single-ended class A emitter follower stage followed by a class A-B emitter follower stage.

The voltage gain of the differential pair arrangement is equal to the product of the voltage gains of the consecutive stages thereof. However, since each but the last stage is loaded by a following stage, the input impedance of this following stage must be taken into account in computing the respective voltage gain. Furthermore, as follows from the above book, due to this load the frequency responses of the respective stages are changed, and more particularly the frequency response of each stage, i.e. the pole of its frequency response characteristic due to its input capacitance, is influenced by every stage following it.

This voltage gain and this frequency response are determined by the choice of the first impedances of each of the differential pairs.

An object of the present invention is to provide a differential pair arrangement of the above known type but wherein the overall voltage gain and the overall frequency response may be more easily tuned.

According to the invention, this object is achieved due to the fact that characterized in that said control electrodes of said transistors of said second differential pair are coupled to said respective junction points of said first impedances and said transistors of said second differential pair via respective second impedances.

In this way, the input impedance of the second differential pair may be changed by adjusting the values of the second impedances. Thus, the overall voltage gain and the overall frequency response of the differential pair arrangement are determined by both the first and second impedances. To be noted that when the first impedances of the first branches of the first differential pair are equal, and the same is true for the first impedances of the first branches of the second differential pair, and also for the second impedances, as is necessary to reduce the common mode voltage gain of the differential pair arrangement, then three values may be chosen to tune the overall voltage gain and the overall frequency response of the arrangement, viz. the values of the first impedances of the first differential pair, the values of the first impedances of the second differential pair, and the values of the second impedances.

To be noted that compared to a differential cascode stage, the addition of the second differential pair with the second impedances has the advantage of providing a higher overall voltage gain and two additional degrees of freedom to tune this overall voltage gain and the overall frequency performance of the arrangement.

Another characteristic feature of the present invention is that said respective output terminals of said differential pair arrangement are cross-coupled to said input terminals thereof via respective feedback impedance arrangements.

Thereby, negative feedback for difference mode signals is obtained. Indeed, although a phase shift of $2\pi$ is obtained by cascading the first and second differential pairs, the feedback impedance arrangements provide negative feedback due to the cross-coupling of the output terminals to the input terminals. When a difference mode input signal is applied across the input terminals, and the voltage at a first one of these input terminals rises, this voltage rise results in a rise of the voltage at a corresponding one of the output terminals which is coupled to a second one of the input terminals via one of the feedback impedance arrangements, and thus results in a rise of the voltage at this second input terminal which is opposed to the drop of the voltage of the difference mode input signal at this terminal corresponding to the rise of the voltage thereof at the first input terminal.

Still another characteristic feature of the present invention is that said feedback impedance arrangements each include an emitter follower coupled between a respective one of said junction points of said first impedances and said transistors of said second differential pair, and a respective one of said output terminals.

Thereby, the differential pair arrangement has a low output resistance, and an external load impedance connected to the output terminals causes substantially no load on the first and second differential pairs so that the open loop overall voltage gain and the open loop overall frequency response of the differential pair arrangement is substantially not affected by such an external load impedance.

Yet another characteristic feature of the present invention is that said feedback impedance arrangements each include a feedback resistance.

These feedback resistances determine the closed loop overall voltage gain of the differential pair arrangement.

The above mentioned and other objects and features of the invention will become more apparent and the invention itself will be best understood by referring to the following description of an embodiment taken in conjunction with the accompanying drawing which represents a differential pair arrangement according to the invention.

The differential pair arrangement includes two differential pairs between a positive pole VDD and a negative pole VSS of a DC supply source. The first differential pair is constituted by two parallel branches in series with a common branch. The first parallel branch comprises the series connection of a resistance R1 and the collector emitter path of a bipolar npn-type transistor T1, whereas the second parallel branch comprises the series connection of a resistance R1' and the collector emitter path of a bipolar npn-type transistor T1'. The common branch consists of a current source CS1. The base electrodes of T1 and T1' are connected to input terminals IN+ and IN- of a differential input of the arrangement. The second differential pair is built in a similar way from resistances R2 and R2', transistors T2 and T2', and a current source CS2. However, the base electrode of transistor T2 is connected to the collector electrode of transistor T1 directly, and to the collector electrode of T2 via a resistance R3. Likewise, the base electrode of transistor T2' is connected to the collector electrode of transistor T1' directly, and to the collector electrode of T2' via a resistance R3'.

The differential pair arrangement further includes between VDD and VSS an emitter follower stage comprising the series connection of the collector emitter path of a bipolar npn-type transistor T3, forwardly biased diodes D1, D2 and D3, and a current source CS3, as well as the series connection of the collector emitter path of a bipolar npn-type transistor T3', forwardly biased diodes D1', D2' and D3', and a current source CS3'. The base electrode of transistor T3 is connected to the collector electrode of T2, whereas the base electrode of transistor T3' is connected to the collector electrode of T2'. The junction point of diode D3 and current source CS3 is coupled back to the base electrode of transistor T1' via a feedback resistance Rf'. Likewise, the junction point of diode D3' and current source CS3' is coupled back to the base electrode of transistor T1 via a feedback resistance Rf. The junction points of D3 and CS3, and of D3' and CS3' are connected to output terminals OUT+ and OUT- of a differential output of the arrangement.

The resistances R1 and R1' have a same value and the same is true for the resistances R2 and R2', for R3 and R3', and for Rf and Rf'. Also the transistors T1 and T1', T2 and T2', and T3 and T3' are matched transistors, i.e. they have the same transistor characteristics.

The operation of the differential pair arrangement is described hereinafter.

An input signal of voltage VIN differentially applied across the terminals of the differential input IN+, IN- of the differential pair arrangement is amplified by the first differential pair and gives rise to a first intermediate differential signal of voltage VM1 appearing between the collector electrodes of transistors T1 and T1'. To be noted that the input signal may be a differential current provided for instance by a reference current source connected to input IN+ and a signal current source connected to input IN-. However, the analysis for an input current is obviously analogous to that for an input voltage. The DC voltage gain of this first differential pair is equal to :

$$\mathrm{Av01} \ = \ \frac{\mathrm{VM1}}{\mathrm{VIN}} \ = \ -\mathrm{gm1} \times \mathrm{RL1}$$

Herein gm1 = Ic1/Vt is the transconductance of the transistors T1 and T1', Ic1 is half the current provided by the current source CS1, and Vt = kT/q with k being Boltzmann's constant, T being the temperature in degrees Kelvin, and q being the electron charge. RL1 = R1∥Rin2 is the load resistance of the first differential pair, wherein ∥ means in parallel, Rin2 = r$\pi$2∥Rm2 is the input resistance of the second

3

differential pair, r$\pi$2 is the small signal input resistance of the transistors T2 and T2',

$$Rm2 \; = \; \frac{R3}{1 - Av02}$$

is the so-called Miller resistance at the input of the second differential pair, and Av02 is the DC voltage gain of the second differential pair which is discussed later.

Thus, the resistances R1, R2 and R3 determine the voltage gain of the first differential pair.

The above intermediate differential signal of voltage VM1 differentially applied across the base electrodes of transistors T2 and T2' of the second differential pair gives rise to a second intermediate differential signal of voltage VM2 appearing between the collector electrodes of the transistors T2 and T2'. The DC voltage gain of this second differential pair is equal to :

$$Av02 \; = \; \frac{VM2}{VM1} \; = \; -gm2 \times RL2$$

Herein, gm2 = Ic2/Vt is the transconductance of the transistors T2 and T2', Ic2 is half the current provided by the current source CS2, and RL2 is the load resistance of the second differential pair : RL2 = Rout2‖Rin3, wherein Rout2 = R2‖Rm2x is the output resistance of the second differential pair,

$$Rm2x \; = \; R3 \times \frac{Av02}{Av02 - 1}$$

is the so-called Miller resistance at the output of the second differential pair, and Rin3 is the input resistance of the emitter follower stage which, as known in the art, is high and may be neglected in the equation for RL2. Thus,

$$Av02 \; = \; \frac{R2 - gm2 \times R2 \times R3}{R2 + R3} \; .$$

The second intermediate differential signal of voltage VM2 is differentially applied between the base electrodes of transistors T3 and T3' of the emitter follower stage and gives rise to a differential output signal of voltage VOUT between the output terminals of the differential output OUT+, OUT- of the differential pair arrangement. The voltage gain of the emitter follower stage is known in the art to be approximately one. The emitter follower stage has a high input impedance and a low output impedance and thus acts as a buffer stage between the second differential pair and an external load impedance connected to the output OUT+, OUT- of the differential pair arrangement. Thereby, the open loop voltage gain, and, as will be clear from equations for the poles of the AC open loop voltage gain, the frequency response thereof, is substantially independent from this external load impedance. Furthermore, due to the diodes D1 to D3 and D1' to D3', the emitter follower stage also realizes a DC level shift of the second intermediate signal provided by the second differential pair. Thereby, the difference in DC bias voltage levels at the input and output of the differential pair arrangement is decreased to such extent that no saturation of transistors T1 and T1' due to DC currents flowing through Rf and Rf' and into the bases of T1 and T1' occurs. Indeed, both differential pairs cause the DC level of the signal to shift over the value of the DC collector-base voltage of its transistors. To be noted that a DC current will flow through the feedback resistances Rf and Rf' when a differential input current is applied to the differential input IN+, IN-, i.e. when the current applied to IN+ is different from the one applied to IN-.

The DC overall open loop voltage gain Av0 of the differential pair arrangement is equal to the product of the voltage gains of the successive stages and is thus approximately equal to :

$$Av0 \; = \; Av01 \times Av02$$

It can be shown that the poles of the AC overall open loop voltage gain are :

$$\tau1 = (rb1\|r\pi1)\times(C\pi1 + C\mu1\times(1\text{-}Av01))$$

wherein rb1 is the parasitic series base resistance of T1, $r\pi1$ is small signal input resistance of the transistors T1 and T1', $C\pi1$ is the base-emitter capacitance of T1, $C\mu1$ is the base-collector capacitance of T1, and Av01 is already defined above;

$$\tau2 = (R1\|Rin2) \times (C\mu1 \times \frac{Av01-1}{Av01} + C\pi2 + C\mu2 \times \frac{Av02-1}{Av02}))$$

wherein $C\pi2$ is the base-emitter capacitance of T2, $C\mu2$ is the base-collector capacitance of T2, and Rin2, $C\mu1$, Av01 and Av02 are already defined above; and

$$\tau3 = (Rout2\|Rin3) \times (C\mu2 \times \frac{Av02-1}{Av02} + C\mu3)$$

wherein $C\mu3$ is the base-collector capacitance of T3, and Rout2, Rin3, $C\mu2$ and $r\pi2$ are already defined above. Thereby, the AC overall open loop voltage gain is :

$$Av = \frac{Av0}{(1+\tau1\times s) \times (1+\tau2\times s) \times (1+\tau3\times s)}$$

wherein s is the complex Laplace-variable.

Since the output signal is fed back to the input over the cascaded connection of two differential pairs each providing a phase shift of $\pi$, and an emitter follower providing no phase shift, the feedback resistances Rf and Rf' constitute a positive feedback for common mode signals. However, as the open loop gain for common mode signals is lower than unity there is no risk for oscillations. Indeed, the common mode voltage gain of a differential pair is equal to half the ratio of its collector load resistance and its common emitter resistance. Since for both the first and the second differential pair this common emitter resistance is the dynamic output resistance of the respective current source which is higher than its collector load resistance which is constituted by the respective collector resistance R1 or R2 in parallel with the input resistance Rin2 or Rin3 of the following stage, this common mode voltage gain is lower than unity for both differential stages. To be noted that the dynamic output resistance of an ideal current source is infinite. The common mode voltage gain of the emitter follower stage also being lower than unity, the overall common mode voltage gain is lower than unity. It should be noted that since at high frequencies the output impedance of a current source may decrease heavily, the stability of the differential pair arrangement must be controlled by properly choosing the resistances R1 and R1', R2 and R2', and R3 and R3' and by properly designing the current sources CS1 and CS2.

For difference mode signals, the feedback resistances Rf and Rf' provide negative feedback since the positive output OUT + is coupled to the negative input IN- via Rf', whereas the negative output OUT- is coupled to the positive input IN + via Rf. Indeed, when a difference mode signal is applied between the input terminals IN + and IN-, a rise of the voltage at IN + is accompanied by a drop of the voltage at IN-. The rise of the voltage at IN + results in a rise of the voltage at OUT + and, via Rf', in a rise of the voltage at IN- which is opposed to the drop of the voltage due to the input signal. Thus, negative feedback is obtained.

The closed loop overall difference mode voltage gain is :

$$Avdm = \frac{VOUT^{+}-VOUT^{-}}{VIN^{+}-VIN^{-}} = \frac{Atr}{Rs}$$

Herein, $VOUT^{+}$ is the voltage at output terminal OUT + , $VOUT^{-}$ is the voltage at output terminal OUT-, $VIN^{+}$ is the voltage at input terminal IN + , $VIN^{-}$ is the voltage at input terminal IN-,

5

$$Atr = \frac{VOUT^+ - VOUT^-}{Iin^+ - Iin^-}$$

is the transimpedance of the differential pair arrangement, $Iin^+$ is the input current flowing into input terminal IN+, $Iin^-$ is input current flowing out of input terminal IN-, and Rs is the output resistance of a voltage source providing the input signal. The transimpedance Atr is equal to :

$$Atr = \frac{-Av \times (Zf \| ZT)}{1 + (Av \times (Zf \| ZT) \times (\frac{1}{Zf}))}$$

Herein, Av is as already computed above but is now approximated as

$$Av = \frac{Av0}{1 + s \times \tau} \quad ,$$

with Av0 the above DC overall open loop voltage gain, s the complex Laplace-variable, and $\tau$ the dominant internal pole of the frequency response of the differential pair arrangement, i.e. $\tau$ is the largest of the above poles $\tau 1$, $\tau 2$ and $\tau 3$, the influence of the other two poles being neglected. Zf is the impedance of the feedback resistance Rf taking a parasitic parallel capacitance Cf into account, and ZT is equal to the input impedance of the differential pair arrangement in parallel with the output impedance of the source providing the input signal and is constituted by a resistance RT in parallel with a capacitance CT.

When $\tau$ is small, i.e. smaller than the external time constants of the differential pair arrangement described later, $1 + s \times \tau$ may be approximated by 1 for values of s in a used frequency spectrum, and the above expression for Atr may be simplified to :

$$Atr = \frac{\dfrac{Av0 \times RT \times Rf}{(Av0 + 1) \times RT + Rf}}{1 + s \times \dfrac{((Av0 + 1) \times Cf + CT) \times RT \times Rf}{(Av0 + 1) \times RT + Rf}}$$

When

$$Cf \ll \frac{CT}{Av0 + 1} \quad and \quad RT \gg \frac{Rf}{Av0 + 1},$$

this expression further simplifies to :

$$Atr = \frac{\dfrac{Av0 \times Rf}{Av0 + 1}}{1 + s \times \dfrac{CT \times Rf}{Av0 + 1}}$$

In order to obtain an optimum performance of the differential pair arrangement, the bandwidth thereof is increased by choosing for T1 and T1' transistors with a minimal input capacitance, i.e. with a low base-to-collector capacitance $C\mu$ and a low base-to-emitter capacitance $C\pi$. Indeed, lowering these input capacitances comes down to lowering CT in the above expression for Atr, and thus lowering the time constant

$$\frac{CT \times Rf}{Av0 + 1}$$

and accordingly increasing the bandwidth of the arrangement. To be noted that when these transistors T1 and T1' are chosen such that their input capacitance is at most equal to the output capacitance of the above mentioned voltage source providing the input signal, a further reduction of these input capacitances only slightly further increases the bandwidth of the differential pair arrangement. Thus, it is clear that an optimal bandwidth of the differential pair arrangement may be reached by choosing a voltage source with a minimal output capacitance.

Then, the noise introduced by the differential pair arrangement is decreased by increasing the feedback resistances Rf and Rf' until the noise introduced by the base currents of T1 and T1' is higher than the noise introduced due to Rf and Rf'. Increasing Rf and Rf' even further only slightly further decreases the noise introduced by the differential pair arrangement.

The open loop voltage gain Av0 is increased by increasing the resistances R3 and R3', thereby again increasing the bandwidth of the differential pair arrangement, until Cf x (Av0 + 1) becomes equal to CT. The bandwidth is then determined by the time constant Rf x Cf instead of

$$\frac{CT \times Rf}{Av0 + 1}.$$

This time constant Rf x Cf should be larger than $\tau$, i.e. it should be larger than $\tau1$, $\tau2$ as well as $\tau3$. The latter time constants increase with increasing open loop voltage gain Av0. To be noted that for determining Av0 three degrees of freedom, viz. the three resistance values R1, R2 and R3, are available.

In this way, the overall voltage gain and frequency response of the differential pair arrangement is determined by the choice of the resistance values R1, R2, R3 and Rf. Compared to the case of two cascaded differential pairs without resistances R3 and R3', an extra degree of freedom is provided for tuning these gain and frequency characteristics.

To be noted furthermore that no complementary transistors are used in the differential pair arrangement whereby matching of the transistors T1 and T1', T2 and T2', and T3 and T3' is simplified.

While the principles of the invention have been described above in connection with specific apparatus, it is to be clearly understood that this description is made only by way of example and not as a limitation on the scope of the invention.

**Claims**

1. Differential pair arrangement including between first and second poles (VDD, VSS) of a DC supply source first and second differential pairs each including the series connection of two parallel individual first branches and a common second branch, each of said first branches including the series connection of a first impedance (R1,R1'/R2,R2') and a main path of a transistor (T1,T1'/T2,T2'), and said second branch including a common current source (CS1/CS2), with control electrodes of said transistors (T1,T1') of said first differential pair constituting respective input terminals (IN+,IN-) of said differential pair arrangement, with control electrodes of said transistors (T2,T2') of said second differential pair being coupled to respective junction points of said first impedances (R1,R1') and said transistors (T1,T1') of said first differential pair, and with junction points of said first impedances (R2,R2') and said transistors (T2,T2') of said second differential pair being coupled to respective output terminals (OUT+,OUT-) of said differential pair arrangement, characterized in that said control electrodes of said transistors (T2,T2') of said second differential pair are coupled to said respective junction points of said first impedances (R2,R2') and said transistors (T2,T2') of said second differential pair via respective second impedances (R3,R3').

2. Differential pair arrangement according to claim 1, characterized in that said respective output terminals (OUT+,OUT-) of said differential pair arrangement are cross-coupled to said input terminals (IN+,IN-) thereof via respective feedback impedance arrangements (T3,D1,D2,D3,CS3, Rf'/T3',D1',D2',D3',CS3',Rf).

3. Differential pair arrangement according to claim 2, characterized in that said feedback impedance arrangements (T3,D1,D2,D3,CS3,Rf'/T3',D1',D2',D3',CS3',Rf) each include an emitter follower (T3,D1,D2,D3,CS3/T3',D1',D2',D3',CS3') coupled between a respective one of said junction points of said first impedances (R2,R2') and said transistors (T2,T2') of said second differential pair, and a respective one of said output terminals (OUT+,OUT-).

**4.** Differential pair arrangement according to claim 2, characterized in that said feedback impedance arrangements (T3,D1,D2,D3,CS3,Rf'/T3',D1',D2',D3',CS3',Rf) each include a feedback resistance (Rf'/Rf).

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | GB-A-1 271 517 (EMI LIMITED)<br>* the whole document *<br>--- | 1 | H03F3/343<br>H03F1/34<br>H03F3/45 |
| Y | ELECTRONICS LETTERS.,<br>vol.000024, no.18, 1 September 1988, ENAGE GB<br>pages 1-1781178 - 1179, XP000001979<br>H. NAKAJIMA ET AL 'WIDEBAND DIRECT-COUPLED DIFFERENTIAL AMPLIFIERS UTILISING ALGAAS/GAAS HBT'S' | 1 | |
| A | * page 1178, left column; figure 1 *<br>--- | 3,4 | |
| A | US-A-3 414 834 (R.A. STUBBS)<br>* column 2, line 32 - column 3, line 10; figure 2 *<br>--- | 1,2 | |
| A | US-A-3 003 113 (E.F.MC NICHOL JR)<br>* column 2, line 7 - line 62; figure 1 *<br>----- | 1-4 | |

TECHNICAL FIELDS
SEARCHED       (Int.Cl.6)

H03F

The present search report has been drawn up for all claims

| Place of search | Date of completion of the search | Examiner |
|---|---|---|
| THE HAGUE | 23 August 1994 | Tyberghien, G |

EPO FORM 1503 03.82 (P04C01)